(19) Europäisches Patentamt
European Patent Office
Office européen des brevets

(11) **EP 4 764 535 A1**

(12) **EUROPEAN PATENT APPLICATION**
published in accordance with Art. 153(4) EPC

(43) Date of publication:
**24.06.2026  Bulletin 2026/26**

(51) International Patent Classification (IPC):
**G01R 31/385** (2019.01)      **G01R 19/165** (2006.01)
**G01R 27/02** (2006.01)

(21) Application number: **24874844.4**

(52) Cooperative Patent Classification (CPC):
**G01R 19/165; G01R 27/02; G01R 31/385;**
Y02E 60/10

(22) Date of filing: **02.08.2024**

(86) International application number:
**PCT/KR2024/011410**

(87) International publication number:
**WO 2025/075285 (10.04.2025 Gazette 2025/15)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **LG Energy Solution, Ltd.
Seoul 07335 (KR)**

(72) Inventor: **KIM, Min Woo
Daejeon 34122 (KR)**

(74) Representative: **Goddar, Heinz J.
Boehmert & Boehmert
Anwaltspartnerschaft mbB
Pettenkoferstrasse 22
80336 München (DE)**

(30) Priority:  **05.10.2023  KR 20230132578**

(54) **METHOD FOR MEASURING AND DIAGNOSING BATTERY CELL VOLTAGE**

(57)    The present invention provides a method for diagnosing measurement of a battery cell voltage including a first voltage across a path resistor calculation process of calculating a voltage across a path resistor connected to an output path of a battery cell to be diagnosed, a second voltage across a path resistor calculation process of calculating the voltage across the path resistor from a resistance value of the output path and a voltage of the battery cell to be diagnosed, a process of comparing the first voltage across the path resistor and the second voltage across the path resistor, and a process of diagnosing that it is an error in measurement according to the result of comparing the first voltage across the path resistor and second voltage across the path resistor.

**FIG. 2.**

**Description**

## TECHNICAL FIELD

The present invention relates to a battery cell voltage measurement circuit, and more particularly, to a method for diagnosing measurement of a battery cell voltage for diagnosing the battery cell voltage measurement circuit.

## BACKGROUND ART

A secondary battery capable of charging and discharging, that is, a battery, is widely used as an energy source for mobile devices such as smart phones. Furthermore, the battery is used as an energy source for eco-friendly vehicles such as an electric vehicle and a hybrid electric vehicle proposed as a solution to air pollution caused by a gasoline vehicle and a diesel vehicle using fossil fuels. The types of applications using the battery are becoming very diverse, and it is expected that the battery will be applied to more fields and products than now in the future.

Currently commercialized available batteries include a nickel cadmium battery, a nickel hydrogen battery, a nickel zinc battery, and a lithium ion battery. Among these batteries, the lithium ion battery is spotlighted due to their advantages of free charge and discharge, very low self-discharge rate, and high energy density because the memory effect hardly occurs compared to the nickel-based battery. In addition, since the lithium ion battery can be manufactured to be lightweight in a small size, the lithium ion battery is used as a power source for mobile devices, and the use range thereof has been expanded as a power source for the electric vehicle, thereby drawing attention as a next-generation energy storage medium.

These batteries are generally used in the form of a battery pack rather than as a single battery cell. The battery pack includes at least one or more battery modules, and the battery module may be composed of a plurality of battery cells. The battery pack has been developed in high capacity and high voltage specifications so that it can be used longer and driven more powerfully in response to consumer demands. For example, as requirements for electric vehicles such as driving range and maximum output increase, the number of battery modules and battery cells that make up a battery pack is increasing. Meanwhile, a battery management system (BMS) is provided to manage the overall state of battery cells, battery modules, or battery packs.

However, in the case of a battery in which a plurality of battery cells are connected, when charge and discharge of the battery is repeated, an imbalance in a charge amount of each battery cell occurs. When discharge of the battery continues in this state of imbalance in the charge amount, a specific battery cell with a low charge amount is overdischarged, thereby making stable operation of the battery difficult. In contrast, when charge of the battery continues in the state of imbalance in the charge amount, a specific battery cell with a high charge amount is overcharged, thereby impairing the safety of the battery. For example, when any one battery cell is in a state having the lowest charge voltage and any other battery cell is in a state having the highest charge voltage, a problem may occur in which the battery cannot be charged as well as discharged even if all other battery cells have an appropriate charge voltage. As such, the imbalance in the charge amount may cause some battery cells to be in an overcharged or overdischarged state, and this problem causes a problem of not being able to stably supply power to the load. In addition, overcharge or overdischarge of a specific battery cell may cause a problem in which not only a capacity of a battery pack decreases, but also the battery pack degrades and the lifespan of the battery pack is shortened. Therefore, it is important to accurately measure a battery cell voltage. That is, accurate measurement of the battery cell voltage is essential to determine the state of each battery cell within a limited space and control the battery cell according to the determined state. When the battery cell voltage is measured abnormally, normal diagnostic functions may not be properly performed, and the accuracy of SOX estimation, including battery performance indicators such as state of charge (SOC) and the state of health (SOH), may be degraded.

Meanwhile, when a battery cell voltage measurement circuit is abnormal, the battery cell voltage may be measured abnormally. Therefore, it is necessary to diagnose whether the battery cell voltage is accurately measured. Conventionally, voltages of lines connected to the battery cell were compared with each other to diagnose the measurement of the battery cell voltage. That is, the voltages measured on two lines connected in parallel with the battery cell are compared with each other, and when a difference between the voltages measured on the lines is larger than a certain level, it is determined that there is a problem with the battery cell voltage measurement circuit. However, the conventional method has a problem in that it cannot diagnose an abnormality in the battery cell voltage measurement circuit when both lines are abnormal.

Examples of the related art include Korean registered patent No. 10-1610908 and Korean unexamined patent publication No. 10-2023-0108604.

## DISCLOSURE OF THE INVENTION

## TECHNICAL PROBLEM

The present invention provides a method for diagnosing measurement of a battery cell voltage in which a battery cell voltage measurement circuit can be diagnosed.

The present invention provides a method for diagnosing measurement of a battery cell voltage for diagnosing a battery cell voltage measurement circuit by comparing a measured value and calculated value of a battery cell voltage.

## TECHNICAL SOLUTION

A method for diagnosing measurement of a battery cell voltage according to embodiments of the present invention comprises a first voltage across a path resistor calculation process of calculating a voltage across a path resistor connected to an output path of a battery cell to be diagnosed, a second voltage across a path resistor calculation process of calculating the voltage across the path resistor from a resistance value of the output path and a voltage of the battery cell to be diagnosed, a process of comparing the first voltage across the path resistor and the second voltage across the path resistor, and a process of diagnosing that it is an error in measurement according to the result of comparing the first voltage across the path resistor and second voltage across the path resistor.

The first voltage across the path resistor is calculated from a difference between a voltage measured in a state that a balancing path of the battery cell to be diagnosed is set and a voltage measured in a state that the balancing path is not set.

The second voltage across the path resistor is calculated from a voltage of the battery cell to be diagnosed, a sum of resistance values of an output path of the battery cell to be diagnosed, and a resistance value of the path resistor.

The second voltage across the path resistor is calculated by dividing the voltage of the battery cell to be diagnosed by the sum of the resistance values of the output path, and multiplying the division result by the resistance value of the path resistor.

When a difference between the first voltage across the path resistor and the second voltage across the path resistor exceeds a predetermined reference value, it is diagnosed as an error in voltage measurement.

A method for diagnosing measurement of a battery cell voltage according to other embodiments of the present invention is a method for diagnosing measurement of a battery cell voltage of a battery pack including a plurality of battery cells and a BMS, and comprises a first voltage across a path resistor calculation process of calculating a voltage across a path resistor connected to an output path of a battery cell to be diagnosed from a voltage at an output terminal of the output path, a second voltage across a path resistor calculation process of calculating the voltage across the path resistor from a resistance value of the output path and a voltage of the battery cell to be diagnosed, and a process of diagnosing that it is an error in voltage measurement when a difference between the first voltage across the path resistor and the second voltage across the path resistor exceeds a predetermined reference value.

The first voltage across the path resistor V11 is calculated as in [Equation 1] from a voltage $V_x$(*balancing ON)* when balancing is performed on the battery cell to be diagnosed and a voltage ($V_x$(*balancing OFF))* when balancing is not performed. on the battery cell to be diagnosed.

[Equation 1]

$$V11 = V_x(balancing\,ON) - V_x(balancing\,OFF)$$

The second voltage across the path resistor V12 is calculated as in [Equation 2] from a voltage of the battery cell to be diagnosed $V_{BCl}$, a sum of resistance values of an output path $R_m$, and a resistance value of the path resistor R12.

[Equation 2]

$$V12 = \frac{V_{BCl}}{R_m} \times R12$$

## ADVANTAGEOUS EFFECTS

According to one embodiment of the present invention, a battery cell voltage measurement diagnosis method compares a voltage across a first path resistor with a voltage across a second path resistor of a battery cell subject to diagnosis, and determines that a measurement error has occurred when the comparison result exceeds a reference value. That is, the error in measurement can be diagnosed by comparing the measured value of the battery cell voltage (the first voltage across the path resistor) and the calculated value (the second voltage across the path resistor). In this case, the first voltage across the path resistor can be calculated by measuring the voltage across the path resistor when performing balancing on the battery cell to be diagnosed and measuring the voltage across the path resistor when balancing is not performed on the battery cell and performing subtraction between the measured voltages. In addition, the second voltage across the path resistor can be calculated using the voltage of the battery cell to be diagnosed and resistance values of a plurality of resistors provided in the output path.

As described above, in the present invention, by comparing the first and second voltages across the path resistor and determining the error in measurement according to the comparison result, the error in measurement can be diagnosed even when both lines connected to one terminal of the battery cell are abnormal or one of the two lines is abnormal. That is, according to the present invention, it is possible to solve the problem of the conventional method of not being able to diagnose an abnormality in the battery cell voltage measurement circuit when both lines connected to one terminal of the battery cell are abnormal.

## BRIEF DESCRIPTION OF THE DRAWINGS

FIG. 1 is a circuit diagram of a circuit for diagnosing measurement of a battery cell voltage according to an embodiment of the present invention.

FIG. 2 is a flowchart of a method for diagnosing measurement of a battery cell voltage according to an embodiment of the present invention.

FIG. 3 is a circuit diagram for describing an operation according to a method for diagnosing measurement of a battery cell voltage of the present invention.

FIG. 4 is a block diagram of a device for diagnosing measurement of a battery cell voltage according to an embodiment of the present invention.

## MODE FOR CARRYING OUT THE INVENTION

Hereinafter, embodiments of the present disclosure will be described in detail with reference to the accompanying drawings. However, the present disclosure is not limited to the embodiments disclosed below, but will be implemented in a variety of different forms, and these embodiments are provided only to complete the disclosure of the present disclosure and to fully inform those skilled in the art of the scope of the invention.

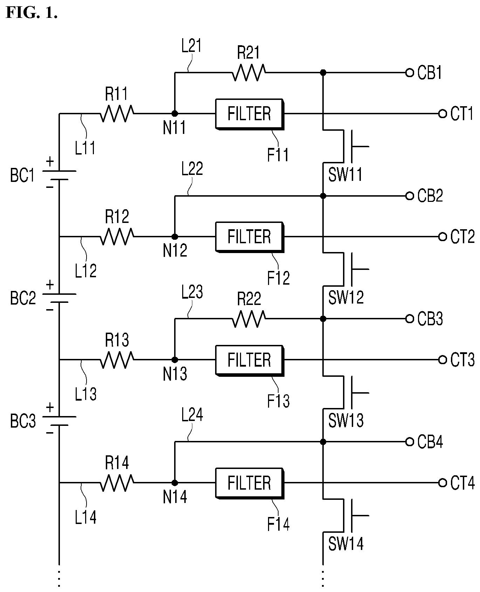

FIG. 1 is a circuit diagram of a method for diagnosing measurement of a battery cell voltage according to an embodiment of the present invention.

Referring to FIG. 1, a circuit for diagnosing measurement of a battery cell voltage according to an embodiment of the present invention may include a plurality of battery cells BC1, BC2, BC3, ..., a plurality of first lines L11, L12, L13, and L14 and plurality of second lines L21, L22, L23, and L24 that are respectively connected to positive terminals (+) and negative terminals (-) of a plurality of battery cells BC1, BC2, and BC3, a plurality of first resistors R11, R12, R13, and R14 and plurality of filters F11, F12, F13, and F14 that are respectively provided on the plurality of first lines L11, L12, L13, and L14, a plurality of second resistors R21 and R22 that are selectively provided on the plurality of second lines L21, L22, L23, and L24, and a plurality of switches SW11, SW12, SW13, and SW14 that connect adjacent second lines L21, L22, L23, and L24 with each other. In addition, a plurality of first measurement pins CT1, CT2, CT3, and CT4 may be respectively provided at respective ends of the plurality of first lines L11, L12, L13, and L14, and a plurality of second measurement pins CB1, CB2, CB3, and CB4 may be respectively provided at respective ends of the plurality of second lines L21, L22, L23, and L24.

The positive terminals (+) and negative terminals (-) of the plurality of battery cells BC1, BC2, and BC3 are connected to the first line L11, L12, L13, and L14 and the second line L21, L22, L23, and L24. In this case, the first lines L11, L12, L13, and L14 and the second lines L21, L22, L23, and L24 are respectively connected in parallel with each other. That is, the positive terminal (+) of the first battery cell BC1 is connected to a (1-1)-th line L11 and a (2-1)-th line L21 that are connected in parallel with each other, and the negative terminal (-) of the first battery cell BC1 is connected to a (1-2)-th line L12 and a (2-2)-th line L22 that are connected in parallel with each other. In addition, the positive terminal (+) of the second battery cell BC2 is connected to the (1-2)-th line L12 and the (2-2)-th line L22 that are connected in parallel with each other. The negative terminal (-) of the second battery cell BC2 is connected to a (1-3)-th line L13 and a (2-3)-th line L23 that are connected in parallel with each other. In addition, the positive terminal (+) of the third battery cell BC3 is connected to the (1-3)-th line L13 and the (2-3)-th line L23 that are connected in parallel with each other, and the negative terminal (-) of the third battery cell BC3 is connected to a (1-4)-th line L14 and a (2-4)-th line L24 that are connected in parallel with each other. That is, the first and second lines connected to a negative terminal (-) of one battery cell are connected to a positive terminal (+) of another battery cell adjacent thereto. In other words, the negative terminals and positive terminals of two adjacent battery cells share the first and second lines.

The first resistors R11, R12, R13, and R14 and filters F11, F12, F13, and F14 are connected in series to the first lines L11, L12, L13, and L14, respectively, and the second resistors R21 and R22 are selectively connected to the second lines L21, L22, L23, and L24. A (2-1)-th resistor R21 is connected to the (2-1)-th line L21, and a (2-2)-th resistor R22 is connected to the (2-3)-th line L23. The second resistors R21 and R22 are alternately connected to the plurality of second lines L21, L22, L23, and L24. In other words, the second resistors R21 and R22 are connected to odd-numbered second lines L21 and L23 and are not connected to even-numbered second lines L22 and L24, among the plurality of second lines L21, L22, L23, and L24. Of course, the second resistors R21 and R22 may be connected to the even numbered second lines L22 and L24 and may not be connected to the odd-numbered second lines L21 and L23, among the plurality of second lines L21, L22, L23, and L24. Meanwhile, the second lines L21, L22, L23, and L24 may respectively branch from the first lines L11, L12, L13, and L14. For example, the second lines L21, L22, L23, and L24 may respectively branch from the nodes N11, N12, N13, and N14 between the first resistors R11, R12, R13, R14 and the filters F11, F12, F13, and F14. In addition, the first measurement pins CT1, CT2, CT3, and CT4 may be respectively provided on the first lines L11, L12, L13, and L14, and the second measurement pins CB1, CB2, CB3, and CB4 may be respectively provided on the second lines L21, L22, L23, and L24. That is, a (1-1)-th measurement pin CT1 and a (2-1)-th measurement pin CB1 are provided on the (1-1)-th line L11 and the (2-1)-th line L21 that are connected in parallel with each other, respectively, a (1-2)-th measurement pin CT2 and a (2-2)-th measurement pin CB2 are provided on the (1-2)-th line L12 and the (2-2)-th line L22 that are connected in parallel with each other, respectively, and a (1-3)-th measurement pin CT3 and a (2-3)-th measurement pin CB3 are provided on the (1-3)th line L13 and the (2-3)th line L23 that are connected in parallel with each other, respectively.

In addition, the second lines L21, L22, L23, and L24 may be connected by the switches SW11, SW12, SW13, and SW14. That is, a first switch SW11 may be provided between the (2-1)-th line L21 and the (2-2)-th line L22, a second switch SW12 may be provided between the (2-2)-th line L22 and the (2-3)-th line L23, and a third switch SW13 may be provided between the (2-3)-th line L23 and the (2-4)-th line L24. The switches SW11, SW12, and SW13 may be turned on or off according to a control signal having a predetermined level to connect or disconnect the second lines L21, L22, L23, and L24 to or from each other. That is, when the first switch SW11 is turned on, the (2-1)-th line L21 and the (2-2)-th L22 may be connected to each other, when the second switch SW12 is turned on, the (2-2)-th line L22 and the (2-3)-th line L23 may be connected to each other, and when the third switch SW13 is turned on, the (2-3)-th line L23 and the (2-4)-th line L24 may be connected to each other.

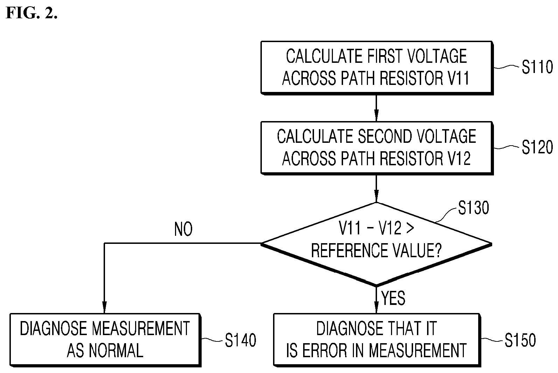

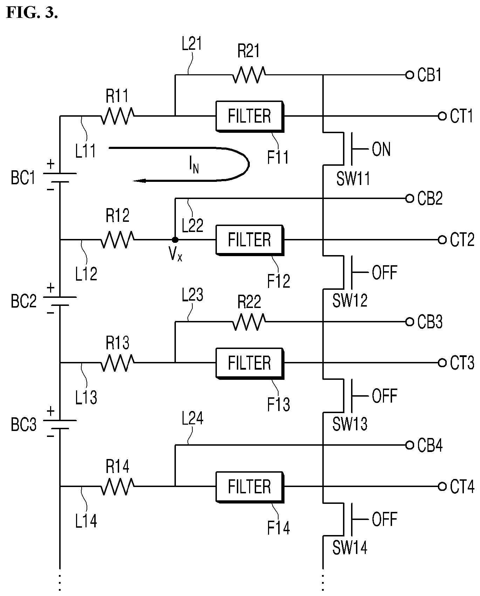

FIG. 2 is a flowchart of a method for diagnosing measurement of a battery cell voltage according to an embodiment of the present invention. In addition, FIG. 3 is a circuit diagram for describing a process of calculating a voltage across a first path resistor according to the method for diagnosing measurement of a battery cell voltage according to an embodiment of the present invention.

Referring to FIG. 2, the method for diagnosing measurement of the battery cell voltage according to an embodiment of the present invention may include a first voltage across a path resistor calculation process of calculating a voltage across a path resistor connected to an output path of a battery cell to be diagnosed from a voltage at an output terminal of an output path (S110), a second voltage across a path resistor calculation process of calculating the voltage across the path resistor from a resistance value of the output path and a voltage of the battery cell to be diagnosed (S120), a process of comparing the first voltage across the path resistor and the second voltage across the path resistor (S130), and a process of diagnosing that it is an error in voltage measurement when a difference between the first voltage and second voltage across the path resistor exceeds a predetermined reference value as a result of comparing the first voltage and second voltage across the path resistor (S150), and a process of diagnosing that it is normal measurement when the difference is within the predetermined reference value (S 140). The method for diagnosing measurement of a battery cell voltage according to an embodiment of the present invention is described for each process as follows.

S110: Balancing of a battery cell to be diagnosed is performed to calculate a first voltage across a path resistor. For example, when a first battery cell BC1 is selected as a battery cell to be diagnosed, a first switch SW11 is turned on and the remaining switches SW12, SW13, and SW14 are turned off to balance the first battery cell BC1. In this case, the current $I_N$ flows along a path shown in FIG. 3. That is, when the first switch SW11 is turned on for balancing the first battery cell BC1, the current $I_N$ flows from the positive terminal of the first battery cell BC1 to the negative terminal of the first battery cell BC1 through a (1-1)-th resistor R11, a (2-1)-th resistor R21, and a (1-2)-th resistor R12. In this case, a voltage drop occurs due to the (1-2)-th resistor R12 and a voltage V11 is measured. Therefore, the voltage V11 before and after balancing may be calculated as in [Equation 1] through a voltage difference before and after the current flows. Here, $V_x$ is a voltage value of the first node N11 where the (2-2)-th line L22 branches from the (1-2)-th line L12, and the voltage value of the first node N11 may be measured at a (1-2)-th measurement pin CT2.

[Equation 1]

$$V11 = V_x(balancing\,ON) - V_x(balancing\,OFF)$$

That is, the first voltage across the path resistor V11 may be calculated by subtracting the voltage applied to the node when balancing of the battery cell to be diagnosed is not performed from the voltage applied to the node when balancing of the battery cell to be diagnosed is performed.

S 120: A second voltage across the path resistor may be calculated because the first and second resistors, etc. applied to the diagnosis circuit, the battery cell voltage, etc. are known. That is, the second voltage across the path resistor may be calculated as in [Equation 2] from the current $I_N$ and a resistance value of the resistor R12 because the current $I_N$ flowing in the output path of the battery cell to be diagnosed and the resistance value of the resistor R12 of the output path are known.

[Equation 2]

$$V12 = I_N \times R12$$

In addition, the current $I_N$ may be calculated as in [Equation 3] from a voltage $V_{BC1}$ of the battery cell to be diagnosed, that is, the first battery cell BC1, and the sum of the resistances values of a (1-1)-th resistor R11, a (2-1)-th resistor R21, and a (1-2)-th resistor R12 on the output path. In [Equation 3], $R_m$ is the sum of the resistance values of the output path.

[Equation 3]

$$I_N = \frac{V_{BC1}}{R11 + R21 + R12} = \frac{V_{BC1}}{R_m}$$

Accordingly, the second voltage across the path resistor V12 may be calculated as in [Equation 4] from [Equation 2] and [Equation 3]. That is, the second voltage across the path resistor V12 may be calculated by dividing the voltage $V_{BC1}$ of the first battery cell BC1 by the sum of the resistance values of the output path $R_m$ and by multiplying the division result by the resistance value of the resistor R12 where the voltage drop occurs.

[Equation 4]

$$V12 = \frac{V_{BC1}}{R11 + R21 + R12} \times R12 = \frac{V_{BC1}}{R_m} \times R12$$

S130, S140, and S150: The first voltage across the path resistor V11 is compared with the second voltage across the path resistor V12 (S130). That is, the measured value and calculated value of the voltage across the path resistor are compared with each other. As a result of the comparison, when the difference between the first voltage across the path resistor V11 and the second voltage across the path resistor V12 is greater than a predetermined reference value, it is diagnosed as an error in voltage measurement (S150), and when the difference is smaller than the reference value, it is diagnosed as normal measurement (S140).

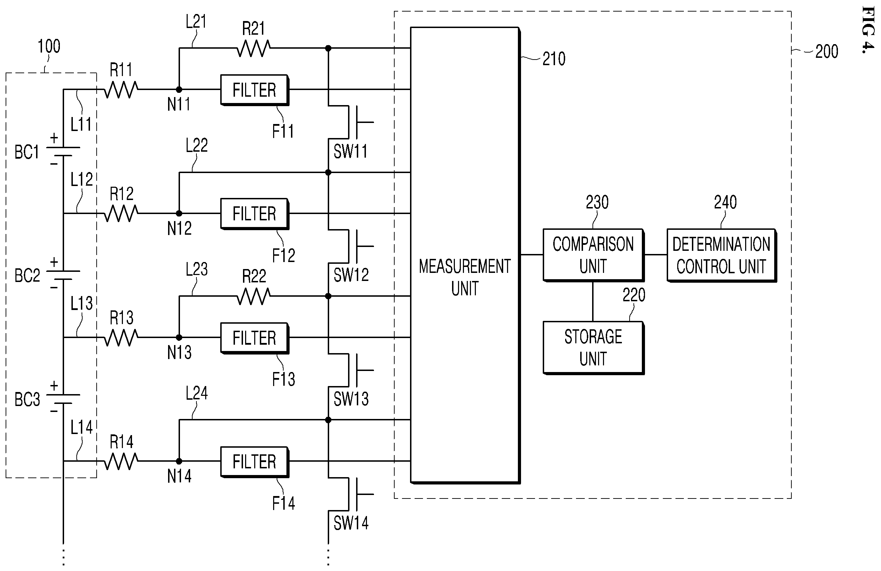

FIG. 4 is a block diagram for describing a configuration of a device for diagnosing measurement of a battery cell voltage according to an embodiment of the present invention. That is, the circuit for diagnosing measurement of a battery cell voltage of FIG. 1 may be connected to the diagnosis device to form a diagnosis device as shown in FIG. 4.

Referring to FIG. 4, a device for diagnosing measurement of a battery cell voltage according to an embodiment of the present invention may include a battery module 100 including a plurality of battery cells BC1, BC2, and BC3, and a diagnosis unit 200 that diagnoses an error in voltage measurement in a battery cell to be diagnosed. Here, the diagnosis unit 200 may be provided within the BMS. In addition, the diagnosis unit 200 may include a measurement unit 210 connected to a plurality of first measurement pins CT1, CT2, CT3, and CT4 and a plurality of second measurement pins CB1, CB2, CB3, and CB4 of the diagnosis circuit to measure the voltage, a storage unit 220 that stores information such as the voltage of the battery cells BC1, BC2, and BC3 constituting the diagnosis circuit, resistance values of a plurality of resistors, current, etc., a comparison unit 230 that compares the first voltage across the path resistor with the second voltage across the path resistor, and a determination control unit 240 that generates a control signal for controlling the switches SW11, SW12, SW13, and SW14 and determines a diagnosis result for measurement according to the comparison result of the comparison unit 230.

The measurement unit 210 is connected to a plurality of first measurement pins CT1, CT2, CT3, and CT4 and a plurality of second measurement pins CB1, CB2, CB3, and CB4. This measurement unit 210 measures a voltage through the plurality of first measurement pins CT1, CT2, CT3, and CT4 and the plurality of second measurement pins CB1, CB2, CB3, and CB4. That is, the measurement unit 210 may measure the voltage of the battery cell to be diagnosed through the first measurement pins CT1, CT2, CT3, and CT4 and the second measurement pins CB1, CB2, CB3, and CB4 that are connected to the battery cell to be diagnosed. In addition, the measurement unit 210 according to the present invention may measure the voltage when cell balancing of a specific battery cell is performed and the voltage when cell balancing of the corresponding battery cell is not performed. That is, the measurement unit 210 measures the voltage when balancing of the battery cell to be diagnosed is performed and the voltage when balancing of the battery cell to be diagnosed is performed is not performed, and calculates the first voltage across the path resistor V11 accordingly.

The storage unit 220 may store the characteristics or specifications of the battery cells BC1, BC2, and BC3 and each component that constitute the diagnosis circuit. That is, the storage unit 220 stores data such as the charge or discharge voltage of the battery cells BC1, BC2, and BC3, a current voltage status of battery cells BC1, BC2, and BC3, resistance values of a plurality of first resistors R11, R12, R13, and R14 constituting the diagnosis circuit, resistance values of a plurality of second resistors R21 and R22, current values of respective battery cells BC1, BC2, and BC3 according to the resistance values of the first and second resistors and the voltage values of the battery cells BC1, BC2, and BC3, etc. In addition, the storage unit 220 may store measured values such as the voltage when cell balancing of a specific battery cell is performed and the voltage when cell balancing of the corresponding battery cell is not performed that are measured by the measurement unit 210.

The comparison unit 230 compares the first voltage across the path resistor and second voltage across the path resistor of the battery cell to be diagnosed. That is, the comparison unit 230 compares the measured value and calculated value of the voltage across the path resistor. To this end, first, the comparison unit 230 uses the voltage when battery cell balancing of the battery cell to be diagnosed is performed and the voltage when battery cell balancing thereof is not performed from the measurement unit 210 to calculate the difference between the voltages. That is, the comparison unit 230 calculates the first voltage across the path resistor of the battery cell to be diagnosed. Next, the comparison unit 230 calculates the second voltage across the path resistor using the voltage of the battery cell to be diagnosed from the storage unit 220 and the sum of resistance values of the plurality of resistors provided in the output path. That is, the comparison unit 230 calculates the second voltage across the path resistor according to [Equation 2] to [Equation 4]. The comparison unit 230 compares the first voltage across the path resistor with the second voltage across the path resistor.

The determination control unit 240 diagnoses a measurement result according to the comparison result of the comparison unit 230. That is, the determination control unit 240 diagnoses that it is an error in measurement when the difference between the first voltage across the path resistor and the second voltage across the path resistor compared by the comparison unit 230 is greater than a set reference value, and diagnoses that it is the normal measurement when the difference is smaller than the set reference value. In this case, when it is diagnosed that it is an error in measurement, it may be determined that at least one of the plurality of first measurement pins CT1, CT2, CT3, and CT4 and the plurality of second measurement pins CB1, CB2, CB3, and CB4 is abnormal, or an abnormality has occurred in the circuit. Meanwhile, the determination control unit 240 may generate control signals for controlling the switches SW11, SW12, SW13, and SW14 to control the switches SW11, SW12, SW13, and SW14. That is, the determination control unit 240 may select a battery cell to be diagnosed and control a switch connected to a measurement pin of the corresponding battery cell so that balancing of the battery cell is performed.

As described above, in the method for diagnosing measurement of a battery cell voltage according to an embodiment of the present invention, the first voltage across the path resistor and the second voltage across the path resistor are compared, and when the comparison result is greater than the reference value, it may be diagnosed as an error in measurement. In this case, the first voltage across the path resistor may be calculated by subtracting the voltage applied across the path resistor when balancing of the battery cell to be diagnosed is performed from the voltage applied across the path resistor when balancing thereof is not performed. In addition, the second voltage across the path resistor may be calculated using the voltage of the battery cell to be diagnosed and the resistance values of a plurality of resistors provided in the output path.

The conventional method has a problem in that an abnormality in the battery cell voltage measurement circuit cannot be diagnosed when both lines connected to one terminal of the battery cell are abnormal. However, in the present invention, the first voltage across the path resistor and the second voltage across the path resistor are compared and an error in measurement is diagnosed according to the comparison result, so that the error in measurement can be diagnosed even when both lines connected to one terminal of the battery cell are abnormal or one of the two line is abnormal.

The technical idea of the present invention as described above has been described in detail according to the above-mentioned embodiments, but it should be noted that the above-described embodiments are for its description and not intended to limit it. In addition, those skilled in the art will understand that various embodiments are possible within the scope of the technical idea of the present invention.

The names of reference numerals used in the description and drawings of the invention are as follows.

BC1, BC2, BC3: battery cell
L11, L12, L13, L14: first line
L21, L22, L23, L24: second line
R11, R12, R13, R14: first resistor
R21, R22: second resistor
SW11, SW12, SW13, SW14: switch
100: battery module
200: BMS
210: measurement unit
220: storage unit
230: comparison unit
240: determination control unit

**Claims**

1. A method for diagnosing measurement of a battery cell voltage, comprising:

    a first voltage across a path resistor calculation process of calculating a voltage across a path resistor connected to an output path of a battery cell to be diagnosed;
    a second voltage across a path resistor calculation process of calculating the voltage across the path resistor from a resistance value of the output path and a voltage of the battery cell to be diagnosed;
    a process of comparing the first voltage across the path resistor and the second voltage across the path resistor; and
    a process of diagnosing that it is an error in measurement according to the result of comparing the first voltage across the path resistor and second voltage across the path resistor.

2. The method of claim 1, wherein
the first voltage across the path resistor is calculated from a difference between a voltage measured in a state that a balancing path of the battery cell to be diagnosed is set and a voltage measured in a state that the balancing path is not set.

3. The method of claim 2, wherein
the second voltage across the path resistor is calculated from a voltage of the battery cell to be diagnosed, a sum of resistance values of an output path of the battery cell to be diagnosed, and a resistance value of the path resistor.

4. The method of claim 3, wherein
the second voltage across the path resistor is calculated by dividing the voltage of the battery cell to be diagnosed by the sum of the resistance values of the output path, and multiplying the division result by the resistance value of the path resistor.

5. The method of claim 4, wherein
when a difference between the first voltage across the path resistor and the second voltage across the path resistor exceeds a predetermined reference value, it is diagnosed as an error in voltage measurement.

6. A method for diagnosing measurement of a battery cell voltage of a battery pack including a plurality of battery cells and a BMS, comprising:

    a first voltage across a path resistor calculation process of calculating a voltage across a path resistor connected to an output path of a battery cell to be diagnosed from a voltage at an output terminal of the output path;
    a second voltage across a path resistor calculation process of calculating the voltage across the path resistor from a resistance value of the output path and a voltage of the battery cell to be diagnosed; and
    a process of diagnosing that it is an error in voltage measurement when a difference between the first voltage across the path resistor and the second voltage across the path resistor exceeds a predetermined reference value.

7. The method of claim 6, wherein
the first voltage across the path resistor V11 is calculated as in [Equation 1] from a voltage $V_x$(*balancing ON)* when balancing is performed on the battery cell to be diagnosed and a voltage ($V_x$(*balancing OFF))* when balancing is not performed. on the battery cell to be diagnosed,

[Equation 1]

$$V11 = V_x(balancing\,ON) - V_x(balancing\,OFF)$$

8. The method of claim 7, wherein
the second voltage across the path resistor V12 is calculated as in [Equation 2] from a voltage of the battery cell to be diagnosed $V_{BC1}$, a sum of resistance values of an output path $R_m$, and a resistance value of the path resistor R12,

[Equation 2]

$$V12 = \frac{V_{BC1}}{R_m} \times R12$$

**FIG. 1.**

**FIG. 2.**

```
       CALCULATE FIRST VOLTAGE      ┐
       ACROSS PATH RESISTOR V11     ├─ S110
                                    ┘
                  │
                  ▼
       CALCULATE SECOND VOLTAGE     ┐
       ACROSS PATH RESISTOR V12     ├─ S120
                                    ┘
                  │
                  ▼
                                    S130
   NO          V11 − V12 >
  ◄────────  REFERENCE VALUE?
                  │ YES
                  ▼
 DIAGNOSE MEASUREMENT    DIAGNOSE THAT IT
    AS NORMAL   S140    IS ERROR IN MEASUREMENT  S150
```

**FIG. 3.**

**FIG 4.**

## INTERNATIONAL SEARCH REPORT

| International application No. |
|---|
| **PCT/KR2024/011410** |

| A. | CLASSIFICATION OF SUBJECT MATTER |
|---|---|

**G01R 31/385**(2019.01)i; **G01R 19/165**(2006.01)i; **G01R 27/02**(2006.01)i

According to International Patent Classification (IPC) or to both national classification and IPC

| B. | FIELDS SEARCHED |
|---|---|

Minimum documentation searched (classification system followed by classification symbols)

G01R 31/385(2019.01); G01R 19/10(2006.01); G01R 31/02(2006.01); G01R 31/36(2006.01); H01M 10/42(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 경로저항(path resistance), 전압 측정(voltage measurement), 진단 (diagnosis)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2022-086397 A (DENSO CORP.) 09 June 2022 (2022-06-09)<br>See paragraphs [0031]-[0038] and figures 1-4. | 1-8 |
| A | KR 10-2020-0012417 A (SK INNOVATION CO., LTD.) 05 February 2020 (2020-02-05)<br>See claim 1 and figures 1-2 and 7. | 1-8 |
| A | KR 10-1735734 B1 (HYUNDAI AUTRON CO., LTD.) 15 May 2017 (2017-05-15)<br>See paragraphs [0026]-[0043] and figures 1-2. | 1-8 |
| A | KR 10-1256952 B1 (LG CHEM, LTD.) 25 April 2013 (2013-04-25)<br>See paragraphs [0033]-[0092] and figures 1-5. | 1-8 |
| A | KR 10-1602434 B1 (LG CHEM, LTD.) 21 March 2016 (2016-03-21)<br>See paragraphs [0023]-[0062] and figures 2-6. | 1-8 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **01 November 2024** | **01 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/011410**

| Patent document cited in search report | | | Publication date (day/month/year) | Patent family member(s) | | | Publication date (day/month/year) |
|---|---|---|---|---|---|---|---|
| JP | 2022-086397 | A | 09 June 2022 | JP | 7428117 | B2 | 06 February 2024 |
| | | | | WO | 2022-113547 | A1 | 02 June 2022 |
| KR | 10-2020-0012417 | A | 05 February 2020 | KR | 10-2648008 | B1 | 15 March 2024 |
| KR | 10-1735734 | B1 | 15 May 2017 | | None | | |
| KR | 10-1256952 | B1 | 25 April 2013 | CN | 102884438 | A | 16 January 2013 |
| | | | | CN | 102884438 | B | 02 March 2016 |
| | | | | CN | 104931841 | A | 23 September 2015 |
| | | | | CN | 104931841 | B | 02 January 2018 |
| | | | | EP | 2544013 | A1 | 09 January 2013 |
| | | | | EP | 2544013 | A4 | 31 July 2013 |
| | | | | EP | 2544013 | B1 | 25 March 2015 |
| | | | | EP | 2730933 | A1 | 14 May 2014 |
| | | | | EP | 2730933 | B1 | 18 April 2018 |
| | | | | JP | 2012-255788 | A | 27 December 2012 |
| | | | | JP | 2012-515354 | A | 05 July 2012 |
| | | | | JP | 5101748 | B2 | 19 December 2012 |
| | | | | JP | 5356579 | B2 | 04 December 2013 |
| | | | | KR | 10-2011-0100863 | A | 15 September 2011 |
| | | | | US | 2011-0285538 | A1 | 24 November 2011 |
| | | | | US | 8902072 | B2 | 02 December 2014 |
| | | | | WO | 2011-108788 | A1 | 09 September 2011 |
| KR | 10-1602434 | B1 | 21 March 2016 | KR | 10-2014-0060170 | A | 19 May 2014 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 101610908

- KR 1020230108604